# EUROPÄISCHE PATENTSCHRIFT

(11) **EP 3 520 218 B1**
(45) Veröffentlichungstag und Bekanntmachung des Hinweises auf die Patenterteilung: **08.11.2023**
(21) Anmeldenummer: 17764573.6
(22) Anmeldetag: 08.09.2017
(51) Int. Cl.: H03K 17/96

(54) **SCHICHTENVERBUND ZUR BEREITSTELLUNG EINES BEDIENELEMENTS FÜR EIN HAUSGERÄT**
LAYER COMPOSITE FOR PROVIDING AN OPERATING ELEMENT FOR A DOMESTIC APPLIANCE
COMPOSITE MULTICOUCHE POUR FOURNIR UN ÉLÉMENT DE COMMANDE POUR UN APPAREIL MÉNAGER

(30) Priorität: 27.09.2016 DE 102016218538
(43) Veröffentlichungstag der Anmeldung: 07.08.2019
(73) Patentinhaber: BSH Hausgeräte GmbH, 81739 München (DE)
(72) Erfinder: FISCHER, Carsten, 93138 Lappersdorf (DE); ROSENWALD, Dirk, 58239 Schwerte (DE)
(86) Internationale Anmeldenummer: PCT/EP2017/072548
(87) Internationale Veröffentlichungsnummer: WO 2018/059908

(56) Entgegenhaltungen:
- EP-A1- 1 918 954
- EP-A1- 2 048 781
- DE-A1-102006 022 965
- DE-A1-102011 079 737
- DE-A1-102013 220 405
- US-A1- 2011 304 484
- US-A1- 2013 248 344

## Beschreibung

Die Erfindung betrifft ein elektronisches Bedienelement für ein Hausgerät, insbesondere für ein Haushaltsgerät.

Hausgeräte, insbesondere Haushaltsgeräte wie z.B. Waschmaschinen oder Spülmaschinen, umfassen typischerweise einzelne mechanische Tasten oder Druckknöpfe, mit denen einzelne Funktionen des Hausgeräts (z.B. Optionen von Wasch- oder Spülprogrammen) ausgewählt werden können. Auf den Tasten bzw. Druckknöpfen oder auf einer Blende neben den Tasten bzw. Druckknöpfen ist typischerweise ein Symbol oder ein Schriftzug angebracht, mit denen die Funktionen angezeigt werden, die durch die Tasten bzw. Druckknöpfe ausgewählt werden können.

Mechanische Tasten bzw. Druckknöpfe können verschmutzen und/oder verschleißen, da sie direkt der (ggf. feuchten) Umgebung eines Hausgeräts ausgesetzt sind. Des Weiteren ist es typischerweise aufwendig, eine Beleuchtung von beschreibenden Symbolen auf den Tasten bzw. Druckknöpfen bereitzustellen. EP 2 048 781 A1 beschreibt einen Schichtverbund mit einer Filterschicht zur Darstellung eines Icons. US 2013 / 248 344 A1 beschreibt einen Schichtverbund mit einer Graphik-Schicht zur Darstellung von Text. US 2011 / 304 484 A1 beschreibt eine Tastatur für ein Mobiltelefon. DE 10 2006 022965 A1 beschreibt einen Lichtleiter mit einer bedruckten Oberfläche. DE 10 2013 220405 A1 beschreibt eine Bedienfolie für eine Kochfeldsteuerung eines Glaskeramikkochfelds.

Das vorliegende Dokument befasst sich mit der technischen Aufgabe, ein Kosten-effizientes und kompaktes Bedienelement für ein Hausgerät bereitzustellen, das vor Verschmutzung und Umwelteinflüssen geschützt ist und das eine Beleuchtung ermöglicht. Die Aufgabe wird durch den Gegenstand des unabhängigen Patentanspruchs gelöst. Vorteilhafte Ausführungsformen sind insbesondere in den abhängigen Patentansprüchen definiert, in nachfolgender Beschreibung beschrieben oder in der beigefügten Zeichnung dargestellt.

Gemäß einem Aspekt der Erfindung wird ein Schichtenverbund zur Bereitstellung eines Bedienelements an einer Bedienoberfläche eines Hausgeräts beschrieben. Der Schichtenverbund kann insbesondere als ein Folienverbund, d.h. als ein Verbund von mehreren, übereinander angeordneten Folien, ausgebildet sein. Der Schichtenverbund kann z.B. hinter die Bedienoberfläche (z.B. hinter eine Glasfront) eines Hausgeräts angeordnet, insbesondere geklebt, werden.

Der Schichtenverbund umfasst eine Träger-Schicht (z.B. eine Träger-Folie) an der eine zumindest teilweise elektrisch leitende Sensor-Schicht, eine elektrische Lichtquelle (z.B. mit ein oder mehreren LEDs) und elektrische Leitungen zur Kontaktierung der Sensor-Schicht und der Lichtquelle angeordnet sind. Diese elektronischen Bauteile können z.B. auf die Träger-Schicht gedruckt worden sein. Die Träger-Schicht kann z.B. PET (Polyethylenterephthalat) umfassen. Die Sensor-Schicht kann dabei Teil eines Sensors (insbesondere eines kapazitiven Sensors) sein, der eingerichtet ist, eine Berührung der Bedienoberfläche in einem Bedienelement-Bereich oberhalb der Sensor-Schicht zu detektieren. Der Bedienelement-Bereich, in dem die Bedienoberfläche berührt werden kann, um das Bedienelement zu betätigen, kann durch die flächenmäßige Ausdehnung der Sensor-Schicht parallel zu der Bedienoberfläche definiert sein.

Die Sensor-Schicht umfasst einen lichtdurchlässigen Bereich und einen lichtblockierenden Bereich, wobei der lichtblockierende Bereich den lichtdurchlässigen Bereich zumindest teilweise umschließt. Insbesondere kann der lichtblockierende Bereich den lichtdurchlässigen Bereich vollständig umschließen. Der lichtdurchlässige Bereich weist dabei eine höhere Transparenz für Licht im sichtbaren Wellenlängen-Bereich auf als der lichtblockierende Bereich. Bevorzugt ist ein Transmissionsgrad für Licht im lichtblockierenden Bereich bei 20%, 10%, 5% oder weniger. Des Weiteren ist bevorzugt ein Transmissionsgrad für Licht im lichtdurchlässigen Bereich bei 70%, 80%, 90% oder mehr.

Die Lichtquelle ist ausgehend von der Bedienoberfläche hinter dem lichtblockierenden Bereich der Sensor-Schicht angeordnet. Dabei ist die Lichtquelle bevorzugt derart angeordnet, dass substantiell kein von der Lichtquelle ausgestrahltes Licht bzw. kein Lichtstrahl direkt (insbesondere ohne zuvor reflektiert und/oder umgeleitet zu werden) von der Lichtquelle an die Bedienoberfläche gelangt.

Der Schichtenverbund umfasst weiter eine optische Schicht (in diesem Dokument auch als Separator-Schicht bezeichnet), die ausgehend von der Bedienoberfläche hinter der Träger-Schicht angeordnet ist und die eingerichtet ist, Licht der Lichtquelle von dem lichtblockierenden Bereich an den lichtdurchlässigen Bereich der Sensor-Fläche zu leiten.

Über die optische Schicht kann somit Licht gezielt an den lichtdurchlässigen Bereich der Sensor-Fläche geleitet werden, z.B. um eine möglichst gleichmäßige Ausleuchtung des lichtdurchlässigen Bereichs zu ermöglichen.

Der Schichtenverbund ermöglicht es, ein Kosten-effizientes, kompaktes und robustes Bedienelement für ein Hausgerät bereitzustellen. Insbesondere kann der Schichtenverbund hinter einer Bedienoberfläche (z.B. hinter einer Glasfront) eines Hausgeräts angeordnet werden. Mit der Sensor-Schicht kann dann eine Berührung der Bedienoberfläche detektiert werden. Dabei wird der Bedienelement-Bereich (d.h. der Bereich, in dem die Bedienoberfläche berührt werden muss, um das Bedienelement zu betätigen) durch die Hinterleuchtung eines lichtdurchlässigen Bereichs der Sensor-Schicht selbst angezeigt. Dabei wird keine separate Schicht mit einer Maske für das Bedienelement benötigt, um den Bedienelement-Bereich anzuzeigen. Es wird somit eine kompakte, Kosten-effiziente und robuste Ausgestaltung eines Bedienelements mit Beleuchtung ermöglicht.

Der lichtdurchlässige Bereich der Sensor-Schicht bildet eine Maske für ein an der Bedienoberfläche darzustellendes Symbol.

Mit anderen Worten, der lichtdurchlässige Bereich hat eine Form, die der Form eines an der Bedienoberfläche darzustellenden Symbols (insbesondere auch eines Schriftzeichens oder eines Schriftzugs) aufweist. In entsprechender Weise weist der lichtblockierende Bereich (der direkt an den lichtdurchlässigen Bereich angrenzt) eine Kontur auf, die zumindest teilweise der Kontur eines an der Bedienoberfläche darzustellenden Symbols aufweist. Bevorzugt umschließt der lichtblockierende Bereich der Sensor-Schicht den lichtdurchlässigen Bereich der Sensor-Schicht vollständig. Ein äußerer Rand des lichtdurchlässigen Bereichs und ein entsprechender innerer Rand des lichtblockierenden Bereichs können dann dem Rand eines an der Bedienoberfläche darzustellenden Symbols entsprechen (die Ränder können insbesondere den gleichen Verlauf aufweisen). So kann direkt durch die Sensor-Schicht selbst ein darzustellendes Symbol an der Bedienoberfläche erzeugt werden, was ein Kosten-effizientes und kompaktes Bedienelement mit Beleuchtung ermöglicht.

Zumindest der lichtblockierende Bereich der Sensor-Schicht ist elektrisch leitend und weist somit sensorische Eigenschaften auf. Mit anderen Worten, es kann zumindest durch den lichtblockierenden Bereich der Sensor-Schicht eine Berührung der Bedienoberfläche detektiert werden. Der lichtblockierende Bereich kann zu diesem Zweck beispielsweise eine kupferhaltige Schicht aufweisen. Aufgrund der Tatsache, dass der lichtblockierende Bereich der Sensor-Schicht den lichtdurchlässigen Bereich der Sensor-Schicht zumindest teilweise umschließt (und direkt an diesen angrenzt) kann typischerweise (aufgrund der unmittelbaren Nähe der beiden Bereiche) auch bei einer Berührung des lichtdurchlässigen Bereichs eine Berührung des Bedienelements zuverlässig detektiert werden, auch wenn der lichtdurchlässige Bereich der Sensor-Schicht durch eine Aussparung in der elektrisch leitenden Sensor-Schicht gebildet wird (und daher nicht elektrisch leitend ist).

Alternativ kann der lichtdurchlässige Bereich der Sensor-Schicht ein lichtdurchlässiges, elektrisch leitendes Material, insbesondere ein TCO (Transparent Conducting Oxide) Material, und/oder eine lichtdurchlässige, elektrisch leitende Struktur, insbesondere eine Mesh-Struktur aus elektrisch leitenden Drähten, umfassen. So kann die Sensor-Schicht auch in dem lichtdurchlässigen Bereich elektrisch leitend und damit sensorisch wirksam gemacht werden. Es können somit die sensorischen Eigenschaften und/oder die Empfindlichkeit der Sensor-Schicht verbessert werden.

Die Sensor-Schicht kann ausgehend von der Bedienoberfläche hinter der Träger-Schicht angeordnet sein. Die Träger-Schicht kann dann als ein Diffusor ausgebildet sein, der eingerichtet ist, Licht, das die Träger-Schicht durchläuft, zu streuen. So kann die Gleichmäßigkeit der Beleuchtung eines Bedienelements an der Bedienoberfläche weiter verbessert werden.

Die optische Schicht kann ein Lichtleitelement umfassen, um Licht zu dem lichtdurchlässigen Bereich der Sensor-Fläche zu leiten. Dabei kann das Lichtleitelement ausgebildet sein, innerhalb des lichtdurchlässigen Bereichs der Sensor-Fläche möglichst gleichmäßig Licht auszukoppeln, um den lichtdurchlässigen Bereich der Sensor-Fläche (und damit die Darstellung des Bedienelements an der Bedienoberfläche) möglichst gleichmäßig auszuleuchten. Die optische Schicht kann weiter eine Aussparung zur Aufnahme der (an der Träger-Schicht befestigten) Lichtquelle und ein Koppelelement (z.B. eine Linse) umfassen, wobei das Koppelelement eingerichtet ist, Licht der Lichtquelle in das Lichtleitelement zu koppeln.

Der Schichtenverbund kann eingerichtet sein, mehrere, entlang der Bedienoberfläche nebeneinander, in unterschiedlichen Bedienelement-Bereichen angeordnete, Bedienelemente bereitzustellen. Mit anderen Worten, der Schichtenverbund kann eine flächenförmige Ausdehnung aufweisen (parallel zu der Bedienoberfläche). In unterschiedlichen Bedienelement-Bereichen können dann auf der flächenförmigen Ausdehnung unterschiedliche Bedienelemente bereitgestellt werden. Zu diesem Zweck kann die Träger-Schicht für die unterschiedlichen Bedienelemente elektrisch voneinander isolierte, separate Sensor-Schichten in den unterschiedlichen Bedienelement-Bereichen der Träger-Schicht umfassen. Insbesondere kann der Schichtenverbund für jedes Bedienelement eine separate Sensor-Schicht aufweisen, mit der eine Berührung der Bedienoberfläche in dem jeweiligen Bedienelement-Bereich detektiert werden kann. Durch die Integration von mehreren Bedienelementen in einem Schichtenverbund können Kosten-effiziente und kompakte Bedienvorrichtungen für Hausgeräte bereitgestellt werden.

Die Träger-Schicht kann für die unterschiedlichen Bedienelemente unterschiedliche Lichtquellen in den unterschiedlichen Bedienelement-Bereichen umfassen (wobei die Lichtquellen separat angesteuert werden können). Die optische Schicht kann ein oder mehrere optische Trennelemente umfassen, die eingerichtet sind, Licht, das von einer Lichtquelle in einem ersten Bedienelement-Bereich ausgeht, an einem Übertritt in einen zweiten Bedienelement-Bereich zu hindern. Ein Trennelement kann zu diesem Zweck einen Transmissionsgrad von 20%, 10%, 5% oder weniger aufweisen. So kann eine separate Beleuchtung der einzelnen Bedienelemente gewährleistet werden. Alternativ oder ergänzend kann die optische Schicht ein oder mehrere optische Reflektionselemente umfassen, die eingerichtet sind, Licht, das von einer Lichtquelle in einem ersten Bedienelement-Bereich ausgeht, an einem Rand des ersten Bedienelement-Bereichs in den ersten Bedienelement-Bereich zurück zu reflektieren. Ein optisches Reflektionselement kann einen Reflektionsgrad von 80%, 90% oder mehr aufweisen. So kann eine intensive und Energie-effiziente Beleuchtung der einzelnen Bedienelemente gewährleistet werden.

Der Schichtenverbund kann weiter eine lichtblockierende Blenden-Schicht (mit einem Transmissionsgrad von 20%, 10%, 5% oder weniger) umfassen, die ausgehend von der Bedienoberfläche vor der Träger-Schicht angeordnet ist, und die lichtdurchlässige Aussparungen in den unterschiedlichen Bedienelement-Bereichen für die unterschiedlichen Bedienelemente aufweist. So kann eine separate Beleuchtung der einzelnen Bedienelemente weiter verbessert werden.

Der Schichtenverbund kann eine Reflektions-Schicht (mit einem Reflektionsgrad von 80%, 90% oder mehr) umfassen, die ausgehend von der Bedienoberfläche hinter der optischen Schicht angeordnet ist, und die eingerichtet ist, Licht zurück in die optische Schicht zu reflektieren. So kann eine intensive und Energie-effiziente Beleuchtung der einzelnen Bedienelemente gewährleistet werden.

Der Schichtenverbund ist bevorzugt flexibel und/oder biegbar, so dass der Schichtenverbund hinter eine doppelt bombierte Bedienoberfläche angeordnet, insbesondere geklebt, werden kann. Dies kann insbesondere durch die Verwendung von Folien in den einzelnen Schichten erreicht werden.

Die Träger-Schicht und die optische Schicht sind bevorzugt derart miteinander verbunden, insbesondere verklebt, dass die Sensor-Schicht und die Lichtquelle vor Aerosolen aus einer Umgebung des Schichtenverbunds geschützt sind. Insbesondere kann die Verbindung derart sein, dass eine Eindringrate von Aerosolen so klein ist, dass während der Lebensdauer eines Hausgeräts eine substantielle, Umwelt-bedingte Alterung der Sensor-Schicht und der Lichtquelle unterbleibt.

Gemäß einem weiteren Aspekt wird eine Bedienvorrichtung für ein Hausgerät beschrieben. Die Bedienvorrichtung umfasst eine Bedienoberfläche (z.B. eine transparent Scheibe), die eingerichtet ist, um durch einen Nutzer auf einer ersten Seite (d.h. auf einer Vorderseite) der Bedienoberfläche berührt zu werden. Außerdem umfasst die Bedienvorrichtung einen in diesem Dokument beschriebenen Schichtenverbund, der an einer zweiten Seite (d.h. an einer Rückseite) der Bedienoberfläche angeordnet, insbesondere geklebt, ist. Des Weiteren umfasst die Bedienvorrichtung eine Steuereinheit, die über zumindest einige der Leitungen des Schichtenverbunds mit der Sensor-Schicht des Schichtenverbunds verbunden ist. Die Steuereinheit ist eingerichtet, in Abhängigkeit von einem Signal auf den zumindest einigen Leitungen zu veranlassen, dass eine Funktion des Hausgeräts ausgeführt wird und/oder dass durch eine Lichtquelle des Schichtenverbunds Licht erzeugt wird oder nicht. Somit kann eine kosteneffiziente, kompakte und zuverlässige Bedienung eines Hausgeräts erfolgen. Des Weiteren kann durch die Separierung von Bedienoberfläche und Sensierung (anhand des Schichtenverbunds) eine optisch wertige Bedienoberfläche bereitgestellt werden.

Gemäß einem weiteren Aspekt wird Hausgerät, insbesondere ein Haushaltsgerät wie eine Waschmaschine, ein Wäschetrockner, ein Herd, ein Ofen, eine Spülmaschine, ein Kühlschrank, etc, beschrieben, das die in diesem Dokument beschriebene Bedienvorrichtung umfasst.

Es ist zu beachten, dass jegliche Aspekte der in diesem Dokument beschriebenen Vorrichtungen in vielfältiger Weise miteinander kombiniert werden können. Insbesondere können die Merkmale der Patentansprüche in vielfältiger Weise miteinander kombiniert werden.

Im Weiteren wird die Erfindung anhand von in den beigefügten Zeichnungen dargestellten Beispielen näher beschrieben. Dabei zeigen
- Figur 1: eine beispielhafte Schichtstruktur für ein Bedienelement;
- Figur 2: eine weitere beispielhafte Schichtstruktur für ein Bedienelement;
- Figur 3: eine Bedienvorrichtung zur Aktivierung einer Funktion eines Hausgeräts;
- Figur 4: ein auf einem Bedienelement dargestelltes beispielhaftes Symbol;
- Figur 5: einen gebogenen Folienverbund;
- Figur 6a: einen beispielhaften Aufbau der Schichten eines Folienverbunds; und
- Figur 6b: einen beispielhaften Aufbau einer Separator-Schicht.

Wie eingangs dargelegt, befasst sich das vorliegende Dokument mit der Bereitstellung eines Kosten-effizienten, kompakten und robusten Bedienelements für ein Hausgerät, wobei das Bedienelement eine Beleuchtung ermöglichen soll.

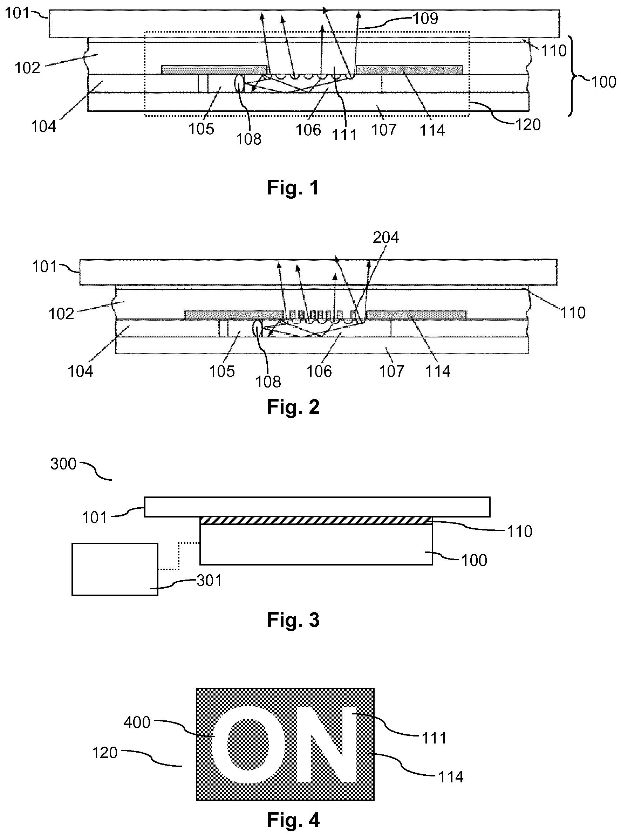

Fig. 1 zeigt einen Schichtenverbund 100 (insbesondere einen Folienverbund), der hinter einer (typischerweise transparenten) Bedienoberfläche 101 (z.B. hinter einer, ggf. gewölbten, Scheibe) angeordnet ist, um ein Bedienelement 120 an der Bedienoberfläche 101 bereitzustellen. Die Bedienoberfläche 101 kann z.B. eine Glasscheibe umfassen. Die Bedienoberfläche 101 kann den Schichtenverbund 100 in zuverlässiger Weise vor Umwelteinflüssen und insbesondere Verschmutzungen schützen. Der Schichtenverbund 100 ist in dem dargestellten Beispiel als eine Folie mit mehreren aufeinanderliegenden Schichten ausgebildet. Eine (von der Bedienoberfläche 101 aus gesehen) oberste Schicht 102 hat die Aufgabe elektrische Schaltelemente des Bedienelements 120 zu tragen und kann daher als Träger-Schicht 102 bezeichnet werden. Die Träger-Schicht 102 ist typischerweise transparent für Licht im sichtbaren Wellenlängen-Bereich. Dabei kann die Träger-Schicht 102 einen relativ hohen Streuungsgrad aufweisen, d.h. die Träger-Schicht 102 kann als Diffusor verwendet werden, um an der Bedienoberfläche 101 eine möglichst gleichmäßige Beleuchtung bereitzustellen.

Unterhalb der Träger-Schicht 102 (ausgehend von der Bedienoberfläche 101) ist eine Sensor-Schicht 114 angeordnet. Die Sensor-Schicht 114 kann insbesondere einen kapazitiven Berührungssensor umfassen. Die Sensor-Schicht 114 kann z.B. zumindest teilweise ein intransparentes elektrisch leitendes Material (z.B. Kupfer) umfassen. Die Sensor-Schicht 114 kann somit eingerichtet sein, die Berührung der Bedienoberfläche 101 durch einen Nutzer zu detektieren. Des Weiteren kann die Sensor-Schicht 114 eingerichtet sein, eine unterhalb der Sensor-Schicht 114 angeordnete Lichtquelle 105 (z.B. mit ein oder mehreren LEDs, Licht Emitting Diodes) abzudecken, so dass das Licht der Lichtquelle 105 nicht direkt von der Lichtquelle 105 an die Bedienoberfläche 101 gelangen kann.

Die Lichtquelle 105 kann in einer Aussparung der Separator-Schicht 104 (in diesem Dokument auch als optische Schicht bezeichnet) angeordnet sein. Des Weiteren kann in der Separator-Schicht 104 ein Lichtleiter 106 und Optik 108 (z.B. mit einer Linse) angeordnet sein, wobei die Optik 108 das Licht der Lichtquelle 105 in den Lichtleiter 106 einkoppelt. Der Lichtleiter 106 kann eingerichtet sein, Licht 109 der Lichtquelle 105 möglichst gleichmäßig über den Querschnitt einer Aussparung bzw. einer Öffnung 111 der Sensor-Schicht 114 zu verteilen. Das Licht 109 kann dann durch die Träger-Schicht 102 zu der Bedienoberfläche 101 gelangen. Unterhalb der Separator-Schicht 104 kann eine Reflektor-Schicht 107 angeordnet sein, die eingerichtet ist, Licht 109 der Lichtquelle 105 zu reflektieren, so dass Licht 109, das in den Lichtleiter 106 eingekoppelt wurde, möglichst vollständig zu der Bedienoberfläche 101 geführt wird.

Die Sensor-Schicht 114 umfasst somit ein oder mehrere lichtdurchlässige Ausschnitte bzw. Bereiche 111, durch die Licht 109 von der Lichtquelle 105 an die Bedienoberfläche 101 gelangen kann. Ein lichtdurchlässiger Bereich 111 kann durch eine Aussparung in der Sensor-Schicht 114 gebildet werden. Alternativ kann ein lichtdurchlässiger Bereich 111 durch Verwendung eines transparenten elektrisch leitenden Materials gebildet werden. So kann die sensorische Wirkung der Sensor-Schicht 114 innerhalb der lichtdurchlässigen Bereiche 111 verbessert werden.

Die ein oder mehreren lichtdurchlässigen Bereiche 111 können dazu verwendet werden, ein Symbol (z.B. ein grafisches Symbols und/oder einen Schriftzug) dazustellen. Mit anderen Worten, die ein oder mehreren lichtdurchlässigen Bereiche 111 können die Form eines Symbols haben. Ein beispielhaftes Symbol 400 ist in Fig. 4 dargestellt. Insbesondere ist in Fig. 4 dargestellt, wie durch den lichtdurchlässigen Bereich 111 einer ansonsten lichtblockierenden Sensor-Schicht 114 ein Symbol 400 (in dem dargestellten Beispiel der Schriftzug "ON") geformt werden kann. Somit kann die Sensor-Schicht 114 direkt dazu verwendet werden, ein erklärendes Symbol 400 für ein Bedienelement 120 bereitzustellen. Es kann somit auf eine dedizierte Schablonen- bzw. Masken-Schicht verzichtet werden. Mit anderen Worten, die Schablone bzw. Maske zur Darstellung eines Symbols 400 kann direkt durch die Sensor-Schicht 114 gebildet werden. So können die Kosten und die Größe eines Schichtenverbunds 100 für ein Bedienelement 120 (insbesondere die Dicke des Schichtenverbunds 100, senkrecht zu der Bedienoberfläche 101) reduziert werden.

Ein Schichtenverbund 100 kann über eine Klebe-Schicht 110 auf die Rückseite der Bedienoberfläche 101 geklebt werden.

Fig. 2 zeigt einen beispielhaften Schichtenverbund 100, bei dem eine Aussparung 111 der Sensor-Schicht 114 mit elektrisch leitenden Drähten 204 (z.B. für eine Mesh-Struktur) durchzogen ist, um auch innerhalb der Aussparung 111 eine sensorische Wirkung bereitzustellen.

Fig. 3 zeigt eine beispielhafte Bedienvorrichtung 300, die den in diesem Dokument beschriebenen Schichtenverbund 100 umfasst. Die Bedienvorrichtung 300 umfasst weiter eine Steuereinheit 301, die eingerichtet ist, zu ermitteln, ob die Bedienoberfläche 101 oberhalb der Sensor-Schicht 114 des Schichtenverbunds 100 durch einen Nutzer berührt wurde. Insbesondere kann anhand der Sensor-Schicht 114 eine Veränderung der Kapazität detektiert werden, die z.B. durch die Berührung der Bedienoberfläche 101 oberhalb der Sensor-Schicht 114 bewirkt wird. Die Steuereinheit 301 kann in Reaktion darauf eine Funktion eines Hausgeräts veranlassen. Beispielhafte Funktionen sind: das Auslösen eines Ablaufprogramms des Hausgeräts und/oder die Auswahl eines bestimmten Ablaufprogramms des Hausgeräts.

Es wird somit Bedienelektronik beschrieben, die als Folienverbund 100 aufgebaut sein kann. Die Bedienelektronik umfasst ein oder mehrere Sensoren 114 für eine kapazitive Bedieneingabe und ein oder mehrere Leuchtmittel 105, die das jeweilige Bedienfeld (d.h. Bedienelement 120) mit Hilfe von optischen Elementen 108, 106 beleuchten. Diese Art der Beleuchtung eignet sich für punktuelle oder balkenförmige Indikation und für vollflächige Symbolhinterleuchtung.

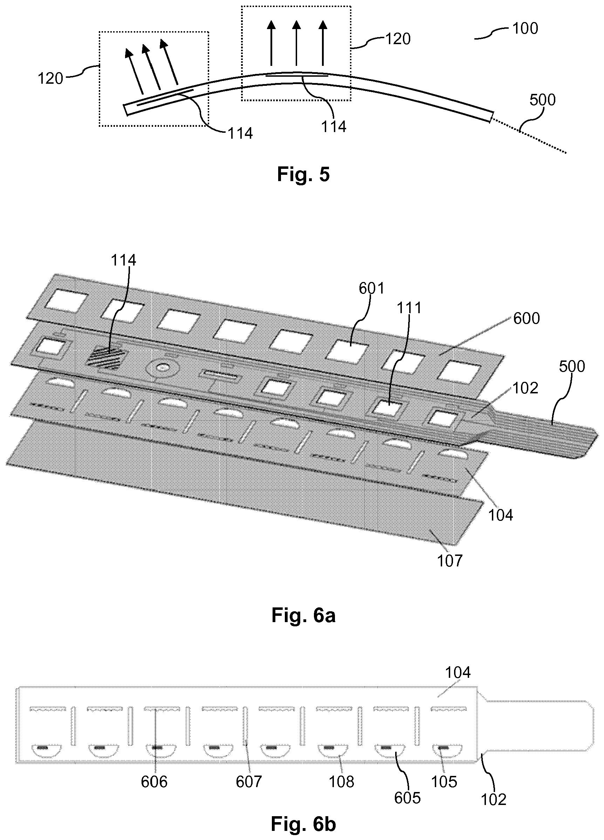

Die elektrisch leitfähigen Zuleitungen 500 (siehe Fig. 5) für die ein oder mehreren Leuchtmittel 105 und für die ein oder mehreren Sensoren 114 sowie die ein oder mehreren Sensoren 114 selbst können auf einer Träger-Folie 102 angeordnet sein. Die Träger-Folie 102 besteht bevorzugt aus einem optisch diffusen Material, um einen homogenen Lichteindruck an der Bedienoberfläche 101 bereitzustellen.

Auf die Träger-Folie 102 kann eine reflektierende Separator-Folie 104 aufgebracht werden, die die einzelnen Bedienfelder 120 eines Folienverbunds 100 voneinander separiert. Die Separator-Folie 104 umfasst für die Beleuchtung der Bedienfelder 120 Ausschnitte, in die Optik-Folien 108 und/oder andere optische Lichtleitelemente 106 eingelegt werden können. Ein Leuchtmittel 105 beleuchtet ein Lichtleitelement 106, welches das Licht 109 reflektiert und in eine spezifische Richtung auskoppelt, wobei die Richtung von der Struktur des Lichtleitelements 106 abhängt. Dabei kann das Licht 109 auch von der Separator-Folie 104 reflektiert werden, um eine klare Abgrenzung zwischen benachbarten Bedienfeldern 120 zu ermöglichen. Der Folienverbund 100 umfasst typischerweise eine weitere Reflektor-Folie 107, die hoch reflektierend ist und als Abschluss des Folienverbunds 100 dient.

Die Zuleitungen für Sensorik 114 und Beleuchtung 105 werden aus dem Folienverbund 100 auf der Träger-Folie 102 herausgeführt und können zum Anschluss an eine Energieversorgung und/oder an eine Steuereinheit 301 mit Kontakten (z.B. mit einem Stecker) ausgestattet werden.

Strukturen in oder an der Träger-Folie 102 können sowohl als kapazitiver Sensor 114 als auch als optische Blende verwendet werden. Unerwünschte Effekte wie z.B. Reflektionen (Korona-Effekt am Lichteinleger) oder seitlicher Lichtaustritt bei LEDs können so zuverlässig vermieden werden. Des Weiteren lassen sich in die Sensorstrukturen 114 Ausschnitte 111 nach Art der anzuzeigenden Symbole 400 einbringen. Das Symbol 400 erscheint bei Hinterleuchtung einer Sensorstruktur 114 nur im transparenten Teil 111 der Sensorstruktur 114, die anderen Bereiche werden durch die Sensorfläche bedeckt. Dies erspart den Einsatz einer zusätzlichen Designfolie. Dieser Effekt kann außerdem durch die Verwendung von spezifisch abgestimmten Optikmaterialien unterstützt werden, die die Lichtstrahlen 109 in eine definierte Richtung leiten. Es findet dabei bevorzugt weder eine Reduktion der Lichtstärke noch eine Veränderung der Lichtfarbe statt.

Aufgrund der direkten Anbindung der Träger-Folie 102 (mit den Sensorstrukturen 114) an die Rückseite der Außenfläche 101 eines Hausgerätes wird die Signalgüte eines kapazitiven Bediensignals gesteigert. Insbesondere können Störeinflüsse bedingt durch Zwischenlagen oder Lufteinschlüsse durch diesen Aufbau vermieden werden.

Des Weiteren ist der Folienverbund 100 typischerweise flexibel und damit geeignet, um einer doppelten Bombierung zu folgen. Dies ist beispielhaft in Fig. 5 dargestellt. Insbesondere zeigt Fig. 5 einen gebogenen Folienverbund 100, der dazu verwendet wird, zwei unterschiedliche Bedienelemente 120 bereitzustellen. Dabei umfasst jedes Bedienelement 120 eine separate Sensor-Schicht 114 zur Erfassung einer Eingabe.

Die Figuren 6a und 6b zeigen beispielhafte Schichten eines Folienverbunds 100. Insbesondere zeigt Fig. 6a eine Blenden-Schicht 600 mit einer Blende, die Aussparungen bzw. transparente Ausschnitte 601 für unterschiedliche Bedienelemente 120 umfasst. Des Weiteren zeigt Fig. 6a eine beispielhafte Träger-Schicht 102 mit unterschiedlichen, nebeneinander angeordneten Sensor-Schichten 114 für unterschiedliche Bedienelemente 120. Die unterschiedlichen Sensor-Schichten 114 weisen unterschiedliche transparente Ausschnitte bzw. Aussparungen 111 auf, um unterschiedliche Symbole 400 für die unterschiedlichen Bedienelemente 120 bereitzustellen. Außerdem zeigt Fig. 6a eine Separator-Schicht 104 und eine Reflektor-Schicht 107.

Details der Separator-Schicht 104 sind in Fig. 6b dargestellt. Die Separator-Schicht 104 ist (gesehen von der Bedienoberfläche 101) hinter der Träger-Schicht 102 angeordnet und umfasst Aussparungen für Lichtquellen 105 für die unterschiedlichen Bedienelemente 120. Des Weiteren umfasst die Separator-Schicht 104 Einkoppelelemente 108, Reflektoren 606 und Trennelemente 607 zur Bereitstellung einer separaten Beleuchtung für die unterschiedlichen Bedienelemente 120.

Die Träger-Schicht 104 kann somit elektrisch leitfähige Strukturen 500 umfassen, die als Zuleitungen für die Versorgung von Lichtquellen 105 (insbesondere Leuchtdioden) verwendet werden. Des Weiteren umfasst die Träger-Schicht 104 elektrisch leitfähige Strukturen, die Sensorflächen 114 und deren Zuleitungen 500 bereitstellen. Außerdem können sich elektrisch leitende Strukturen auf der Träger-Schicht 104 befinden, auf die (weitere) elektronische Bauteile aufgebracht werden und angesteuert werden können. Elektronische Komponenten können durch Montage mittels Kleben oder Löten und/oder durch Druckverfahren (flexible printed electronics) auf die Träger-Schicht 104 aufgebracht werden.

Elektronische Leuchtmittel 105 auf der Träger-Schicht 102 können zur Beleuchtung von unterschiedlichen Anzeige- und Bedienfeldern (insbesondere von unterschiedlichen Bedienelementen 120) bereitgestellt werden. Die Strukturen 114 für die Sensierung von Bediensignalen können gleichzeitig als Maskierung für zu beleuchtende Formen und Symbole 400 genutzt werden. Dafür kann die elektrisch leitfähige aber lichtundurchlässige Sensorfläche 114 entsprechend der darzustellenden Form oder entsprechend dem darzustellenden Symbol 400 ausgespart werden. Die Sensorfläche kann auch (zumindest teilweise lichtdurchlässig (z.B. anhand von Mesh-Structures 204) gestaltet werden, um eine Durchleuchtung zu ermöglichen.

Die Träger-Schicht 102 kann werkstoffseitig optische Eigenschaften besitzen, die eine gleichmäßige und/ oder eine gerichtete Lichtverteilung begünstigen. Das führt zu einer homogenen Lichtverteilung und Beleuchtung eines Bedienfeldes 120 an der Bedienoberfläche 101.

Zur lokalen Begrenzung und zur homogenen Ausleuchtung eines Anzeige- und Bedienfeldes 120, kann eine Separator-Schicht 104 verwendet werden. Die Separator-Schicht 104 besitzt Durchbrüche 605, in die die einzelnen Lichtquellen 105 der Träger-Schicht 104 eintauchen. Das abgegebene Licht 109 einer Lichtquelle 105 tritt dabei in eine Struktur 106 der Separator-Schicht 104 ein und wird in bestimmter Art und Weise reflektiert und gestreut. Die Separator-Schicht 104 besitzt an den Positionen der zu beleuchtenden Bedienfelder bzw. Bedienelemente 120 bestimmte Strukturierungen seiner Oberfläche, damit das eingestrahlte Licht 109 der Leuchtmittel 105 an diesen Positionen zielgerichtet abgestrahlt werden kann. Die Strukturierung wirkt weiterhin in der Art, dass eine homogene Lichtverteilung stattfindet. Zur lokalen Begrenzung des eingestrahlten Lichts 109 auf die zu beleuchtenden Bedienfelder bzw. Bedienelemente 120 können z.B. Durchbrüche 607 als Trennelemente eingebracht werden, die eine Reflektion des ankommenden Lichts 109 zurück in den zu beleuchtenden Bereich bewirken.

Die Separator-Schicht 104 kann durch Kunststoff-Spritzgussverfahren und/oder durch Stanzverfahren und/oder durch abbrasive Fertigungsverfahren hergestellt werden.

Für die Begrenzung der beleuchteten Fläche kann zusätzlich eine weitere Blenden-Schicht 600 verwendet werden, die die Funktion einer Maske bzw. einer optischen Blende besitzt. Gleichzeitig kann die Blenden-Schicht 600 als Klebe-Schicht 110 ausgeführt sein, um den Folienverbund 100 an der Bedienoberfläche 101 zu befestigen.

Zur Steigerung der auskoppelbaren Lichtmenge aus der beleuchteten Bedienfläche, kann zusätzlich auf der Unterseite der Separator-Schicht 104 eine Reflektor-Schicht 107 aufgebracht werden. Lichtstrahlen, die aus der Separator-Schicht 104 in Richtung der Reflektor-Schicht 107 verlaufen, werden durch die reflektierende Oberfläche der Reflektor-Schicht 107 wieder in Richtung der Separator-Schicht 104 reflektiert. Dadurch erhöht sich die zur Beleuchtung zur Verfügung stehende Lichtmenge.

Die Separator-Schicht 104 kann aus einem steifen Trägermaterial (z.B. Leiterplatte) oder aus einem flexiblen Trägermaterial (z.B. Folie) bestehen. Alle Schichten 600, 102, 104, 107 können mit einem Klebstoff (z.B. mit einem doppelseitigen Klebeband oder mit flüssigem Kleber) zusammengefügt werden, um einen Folienverbund 100 zu bilden.

Der in diesem Dokument beschriebene Aufbau eines Bedienelements 100 ermöglicht eine kompakte Bauweise mit einer hohen Funktionalitätsdichte bei einem kleinen Einbauvolumen. Des Weiteren kann das Bedienelement 100 flexibel ausgebildet werden, um einer einfach oder doppelt bombierten Geometrie von Bedienoberflächen 101 zu folgen. Außerdem kann dadurch, dass die elektronischen Bauteile 104, 105 des Bedienelements 100 eingeschlossen und durch einen Klebeverbund weitgehend dicht gegenüber Aerosolen ist, die Robustheit und Lebensdauer gesteigert werden.

Oberhalb der Sensor-Schicht 114 befinden sich keine zusätzlichen Luftstrecken, so dass die Signalgüte eines kapazitiven Sensors gesteigert wird. Des Weiteren wird durch die Vermeidung von Luftstrecken und durch die direkte Anbindung an die Bedienoberfläche 101 die Robustheit in Bezug auf EMV (Elektromagnetische Verträglichkeit) erhöht. Durch Verwendung einer diffusen Schaltungsträger-Folie 102 kann auf die Verwendung einer separaten Diffusor-Folie verzichtet werden, so dass Kosten und Größe des Bedienelements 120 reduziert werden können. Außerdem kann die Symbolbedruckung auf einer Bedienoberfläche 101 durch Aussparungen 111 der Sensorfläche 114, die die Form eines darzustellenden Symbols 400 aufweisen, eingespart werden (Prinzip Maskenbeleuchtung und Projektion).

Es können mehrere elektronische Bauteile 104, 105 in den Folienverbund 100 eingebracht werden, um das Einbauvolumen zu reduzieren, um die Schaltungs-Performanz zu steigern und/oder um die Anzahl von Anschlusskontakten zu externen Modulen 301 zu reduzieren. Insbesondere können in einem Folienverbund 100 mehrere separate Bedienelemente 120 (mit mehreren separaten Sensoren 114 und ggf. Lichtquellen 105) bereitgestellt werden.

Durch den in diesem Dokument beschriebenen Aufbau können punktförmige, balkenförmige und/oder flächige Beleuchtungsfelder für Bedienelemente 120 bereitgestellt werden. Des Weiteren kann der beschriebene Folienverbund 100 in bereits vorhandene Baugruppen durch Einkleben oder durch mechanische Kopplung (z.B. anhand von Klemmen, Schnappvorrichtung, Klipphalter, etc.) eingebunden werden.

Die vorliegende Erfindung ist nicht auf die gezeigten Ausführungsbeispiele beschränkt. Insbesondere ist zu beachten, dass die Beschreibung und die Figuren nur das Prinzip des vorgeschlagenen Schichtenverbunds 100 bzw. der vorgeschlagenen Bedienvorrichtung 300 veranschaulichen sollen.

## Patentansprüche

1. Schichtenverbund (100) nämlich Folienverbund zur Bereitstellung eines Bedienelements (120) an einer Bedienoberfläche (101) eines Hausgeräts, der Schichtenverbund (100) **gekennzeichnet durch**,
- eine Träger-Schicht (102) an der eine zumindest teilweise elektrisch leitende Sensor-Schicht (114), wobei die Sensor-Schicht (114) Teil eines kapazitiven Sensors ist, der eingerichtet ist, eine Berührung der Bedienoberfläche (101) oberhalb der Sensor-Schicht (114) zu detektieren, eine elektrische Lichtquelle (105) und elektrische Leitungen (500) zur Kontaktierung der Sensor-Schicht (114) und der Lichtquelle (105) angeordnet sind;
- wobei die Sensor-Schicht (114) einen lichtdurchlässigen Bereich (111) und einen elektrisch leitenden lichtblockierenden Bereich aufweist; wobei der lichtblockierende Bereich den lichtdurchlässigen Bereich (111) zumindest teilweise umschließt; wobei die Lichtquelle (105) ausgehend von der Bedienoberfläche (101) hinter dem lichtblockierenden Bereich der Sensor-Schicht (114) angeordnet ist; und
- eine optische Schicht (104), die ausgehend von der Bedienoberfläche (101) hinter der Träger-Schicht (102) angeordnet ist und die eingerichtet ist, Licht (109) der Lichtquelle (105) von dem lichtblockierenden Bereich an den lichtdurchlässigen Bereich (111) der Sensor-Fläche (114) zu leiten; wobei der lichtdurchlässige Bereich (111) der Sensor-Schicht (114) eine Maske für ein an der Bedienoberfläche (101) darzustellendes Symbol (400) bildet und dazu eine Kontur des Symbols (500) aufweist; wobei der lichtblockierende Bereich der Sensor-Schicht (114), der direkt an den lichtdurchlässigen Bereich (111) der Sensor-Schicht (114) angrenzt, die Kontur des Symbols (400) aufweist, so dass durch die Sensor-Schicht (114) selbst das an der Bedienoberfläche (101) darzustellende Symbol (400) gebildet wird;
- wobei die Träger-Schicht (102) und die optische Schicht (104) derart miteinander verbunden, insbesondere verklebt, sind, dass die Sensor-Schicht (114) und die Lichtquelle (105) vor Aerosolen aus einer Umgebung des Schichtenverbunds (100) geschützt sind.

2. Schichtenverbund (100) gemäß dem vorhergehenden Anspruch, wobei der lichtdurchlässige Bereich (111) der Sensor-Schicht (114) eine Aussparung in einer elektrisch leitenden und lichtblockierenden Schicht, insbesondere in einer kupferhaltigen Schicht, der Sensor-Schicht (114) umfasst.

3. Schichtenverbund (100) gemäß einem der vorhergehenden Ansprüche, wobei der lichtdurchlässige Bereich (111) der Sensor-Schicht (114)
- ein lichtdurchlässiges, elektrisch leitendes Material, insbesondere ein TCO, Transparent Conducting Oxide, Material, umfasst; und/oder
- eine lichtdurchlässige, elektrisch leitende Struktur, insbesondere eine Mesh-Struktur aus elektrisch leitenden Drähten, umfasst.

4. Schichtenverbund (100) gemäß einem der vorhergehenden Ansprüche, wobei
- die Sensor-Schicht (114) ausgehend von der Bedienoberfläche (101) hinter der Träger-Schicht (102) angeordnet ist; und
- die Träger-Schicht (102) als ein Diffusor ausgebildet ist, der eingerichtet ist, Licht (109), das die Träger-Schicht (102) durchläuft, zu streuen.

5. Schichtenverbund (100) gemäß einem der vorhergehenden Ansprüche, wobei die optische Schicht (104) umfasst,
- ein Lichtleitelement (106), um Licht (109) zu dem lichtdurchlässigen Bereich (111) der Sensor-Fläche (114) zu leiten;
- eine Aussparung (605) zur Aufnahme der Lichtquelle (105); und
- ein Koppelelement (108), das eingerichtet ist, Licht (109) der Lichtquelle (105) in das Lichtleitelement (106) zu koppeln.

6. Schichtenverbund (100) gemäß einem der vorhergehenden Ansprüche, wobei
- der Schichtenverbund (100) eingerichtet ist, mehrere, entlang der Bedienoberfläche (101) nebeneinander, in unterschiedlichen Bedienelement-Bereichen angeordnete, Bedienelemente (120) bereitzustellen; und
- die Träger-Schicht (102) für die unterschiedlichen Bedienelemente (120) elektrisch voneinander isolierte, separate Sensor-Schichten (104) in den unterschiedlichen Bedienelement-Bereichen der Träger-Schicht (102) umfasst.

7. Schichtenverbund (100) gemäß Anspruch 6, wobei
- die Träger-Schicht (102) für die unterschiedlichen Bedienelemente (120) unterschiedliche Lichtquellen (105) in den unterschiedlichen Bedienelement-Bereichen umfasst;
- die optische Schicht (104) ein oder mehrere optische Trennelemente (607) umfasst, die eingerichtet sind, Licht (109), das von einer Lichtquelle (105) in einem ersten Bedienelement-Bereich ausgeht, an einem Übertritt in einen zweiten Bedienelement-Bereich zu hindern; und/oder
- die optische Schicht (104) ein oder mehrere optische Reflektionselemente (606) umfasst, die eingerichtet sind, Licht (109), das von einer Lichtquelle (105) in einem ersten Bedienelement-Bereich ausgeht, an einem Rand des ersten Bedienelement-Bereichs in den ersten Bedienelement-Bereich zurück zu reflektieren.

8. Schichtenverbund (100) gemäß einem der Ansprüche 6 bis 7, wobei der Schichtenverbund (100) weiter eine lichtblockierende Blenden-Schicht (600) umfasst, die ausgehend von der Bedienoberfläche (101) vor der Träger-Schicht (102) angeordnet ist, und die lichtdurchlässige Aussparungen (601) in den unterschiedlichen Bedienelement-Bereichen für die unterschiedlichen Bedienelemente (120) aufweist.

9. Schichtenverbund (100) gemäß einem der vorhergehenden Ansprüche, wobei der Schichtenverbund (100) weiter eine Reflektions-Schicht (107) umfasst, die ausgehend von der Bedienoberfläche (101) hinter der optischen Schicht (104) angeordnet ist, und die eingerichtet ist, Licht (109) zurück in die optische Schicht (104) zu reflektieren.

10. Schichtenverbund (100) gemäß einem der vorhergehenden Ansprüche, wobei der Schichtenverbund (100) flexibel ist, so dass der Schichtenverbund (100) hinter eine doppelt bombierte Bedienoberfläche (101) angeordnet, insbesondere geklebt, werden kann.

11. Bedienvorrichtung (300) für ein Hausgerät, wobei die Bedienvorrichtung (300) umfasst,
- eine Bedienoberfläche (101), die eingerichtet ist, um durch einen Nutzer auf einer ersten Seite der Bedienoberfläche (101) berührt zu werden;
- ein Schichtenverbund (100) gemäß einem der vorhergehenden Ansprüche, der an einer zweiten Seite der Bedienoberfläche (101) angeordnet, insbesondere geklebt, ist; und
- eine Steuereinheit (301), die über zumindest einige der Leitungen (500) des Schichtenverbunds (100) mit der Sensor-Schicht (114) des Schichtenverbunds (100) verbunden ist; wobei die Steuereinheit (301) eingerichtet ist, in Abhängigkeit von einem Signal auf den zumindest einigen Leitungen (500) zu veranlassen, dass eine Funktion des Hausgeräts ausgeführt wird und/oder dass durch die Lichtquelle (105) des Schichtenverbunds (100) Licht (109) erzeugt wird oder nicht.

12. Hausgerät, insbesondere ein Haushaltsgerät, das eine Bedienvorrichtung (300) gemäß Anspruch 11 umfasst.

## Claims

1. Layer composite (100) namely film composite for providing an operating element (120) on an operating interface (101) of a household appliance, the layer composite (100) being **characterised by**,
- a carrier layer (102) on the one at least partially electrically conducting sensor layer (114), wherein the sensor layer (114) is part of a capacitive sensor which is designed to detect contact with the operating interface (101) above the sensor layer (114), an electrical light source (105) and electrical lines (500) for making contact with the sensor layer (114) and the light source (105);
- wherein the sensor layer (114) has a light-permeable region (111) and an electrically conducting light-blocking region, wherein the light-blocking region encloses the light-permeable region (111) at least partially; wherein the light source (105) starting from the operating interface (101) is arranged between the light-blocking region of the sensor layer (114); and
- an optical layer (104), which, starting from the operating interface (101), is arranged behind the carrier layer (102) and is designed to conduct light (109) of the light source (105) from the light-blocking region to the light-permeable region (111) of the sensor surface (114); wherein the light-permeable region (111) of the sensor layer (114) forms a mask for a symbol (400) to be represented on the operating interface (101) and to this end has a contour of the symbol (500); wherein the light-blocking region of the sensor layer (114), which directly adjoins the light-permeable region (111) of the sensor layer (114), has the contour of the symbol (400) so that by means of the sensor layer (114) itself the symbol (400) to be represented on the operating interface (101) is formed;
- wherein the carrier layer (102) and the optical layer (104) are connected, in particular glued, to one another, so that the sensor layer (114) and the light source (105) are protected against aerosols from an environment of the layer composite (100).

2. Layer composite (100) according to the preceding claim, wherein the light-permeable region (111) of the sensor layer (114) comprises a cutout in an electrically conducting and light-blocking layer, in particular in a layer containing copper, of the sensor layer (114).

3. Layer composite (100) according to one of the preceding claims, wherein the light-permeable region (111) of the sensor layer (114)
- comprises a light-permeable, electrically conducting material, in particular a TCO, Transparent Conducting Oxide material; and/or
- comprises a light-permeable, electrically conducting structure, in particular a mesh structure comprising electrically conducting wires.

4. Layer composite (100) according to one of the preceding claims, wherein
- the sensor layer (114), starting from the operating interface (101), is arranged behind the carrier layer (102); and
- the carrier layer (102) is embodied as a diffusor, which is designed to scan light (109) which passes through the carrier layer (102).

5. Layer composite (100) according to one of the preceding claims, wherein the optical layer (104) comprises,
- a light conducting element (106), in order to conduct light (109) to the light-permeable region (111) of the sensor surface (114),
- a cutout (605) for receiving the light source (105); and
- a coupling element (108), which is designed to couple light (109) of the light source (105) into the light conducting element (106).

6. Layer composite (100) according to one of the preceding claims, wherein
- the layer composite (100) is designed to provide a number of operating elements (120) arranged adjacent to one another along the operating interface (101) and in different operating element regions; and
- the carrier layer (102) for the different operating elements (120) comprises separate senor layers (104) which are electrically isolated from one another in the different operating element regions of the carrier layer (102).

7. Layer composite (100) according to claim 6, wherein
- the carrier layer (102) for the different operating elements (120) comprises different light sources (105) in the different operating element regions;
- the optical layer (104) comprises one or more optical separating elements (607), which are designed to obstruct light (109), which emanates from a light source (105) in a first operating element region, from passing into a second operating element region; and/or
- the optical layer (104) comprises one or more optical reflection elements (606), which are designed to reflect light (109), which emanates from a light source (105) in a first operating element region, back to an edge of the first operating element region into the first operating element region.

8. Layer composite (100) according to one of claims 6 to 7, wherein the layer composite (100) further comprises a light-blocking diaphragm layer (600), which, starting from the operating interface (101), is arranged in front of the carrier layer (102) and has the light-permeable cutouts (601) in the different operating element regions for the different operating elements (120).

9. Layer composite (100) according to one of the preceding claims, wherein the layer composite (100) further comprises a reflection layer (107), which, starting from the operating interface (101), is arranged behind the optical layer (104) and which is designed to reflect light (109) back into the optical layer (104).

10. Layer composite (100) according to one of the preceding claims, wherein the layer composite (100) is flexible so that the layer composite (100) can be arranged, in particular glued, behind a double embossed operating interface (101).

11. Operating device (300) for a household appliance, wherein the operating device (300) comprises,
- an operating interface (101) which is designed to be contacted by a user on a first side of the operating interface (101),
- a layer composite (100) according to one of the preceding claims, which is arranged, in particular glued, to a second side of the operating interface (101), and
- a control unit (301) which is connected to the sensor layer (114) of the layer composite (100) by way of at least some of the lines (500) of the layer composite (100), wherein the control unit (301) is designed to trigger, as a function of a signal on the at least some of the lines (500), that a function of the household appliance is executed and/or that light (109) is generated or not by the light source (105) of the layer composite (100).

12. Household appliance, in particular a domestic appliance, which comprises an operating device (300) according to claim 11.

## Revendications

1. Composite multicouches (100) notamment composite de films pour la mise à disposition d'un élément de commande (120) sur une surface de commande (101) d'un appareil ménager, le composite multicouches (100) étant **caractérisé par**
- une couche de support (102) sur laquelle sont disposés une couche de capteur au moins partiellement conductrice d'électricité (114), la couche de capteur (114) faisant partie d'un capteur capacitif, lequel est aménagé afin de détecter un effleurement de la surface de commande (101) au-dessus de la couche de capteur (114), une source lumineuse électrique (105) et des câbles électriques (500) pour le contact de la couche de capteur (114) et de la source lumineuse (105) ;
- dans lequel la couche de capteur (114) présente une zone translucide (111) et une zone opaque conductrice d'électricité ; dans lequel la zone opaque entoure au moins partiellement la zone translucide (111) ; dans lequel la source lumineuse (105) est disposée au départ de la surface de commande (101) derrière la zone opaque de la couche de capteur (114) ; et
- une couche optique (104) disposée au départ de la surface de commande (101) derrière la couche de support (102) et aménagée afin de diriger la lumière (109) de la source lumineuse (105) de la zone opaque vers la zone translucide (111) de la surface de capteur (114) ; dans lequel la zone translucide (111) de la couche de capteur (114) constitue un masque pour un symbole (400) à représenter sur la surface de commande (101) et présente à cet effet un contour du symbole (500) ; dans lequel la zone opaque de la couche de capteur (114), directement contiguë à la zone translucide (111) de la couche de capteur (114), présente le contour du symbole (400), de sorte que la couche de capteur (114) constitue elle-même le symbole (400) à représenter sur la surface de commande (101) ;
- dans lequel la couche de support (102) et la couche optique (104) sont reliées, en particulier collées, de telle sorte l'une à l'autre que la couche de capteur (114) et la source lumineuse (105) sont protégées des aérosols issus d'un environnement du composite multicouches (100).

2. Composite multicouches (100) selon la revendication précédente, dans lequel la zone translucide (111) de la couche de capteur (114) comprend un évidement dans une couche conductrice d'électricité et opaque, en particulier dans une couche contenant du cuivre, de la couche de capteur (114).

3. Composite multicouches (100) selon l'une des revendications précédentes, dans lequel la zone translucide (111) de la couche de capteur (114)
- comprend un matériau translucide, conducteur d'électricité, en particulier un matériau OCT, Oxyde Conducteur Transparent ; et/ou
- comprend une structure translucide, conductrice d'électricité, en particulier une structure maillée en fils conducteurs d'électricité ;

4. Composite multicouches (100) selon l'une des revendications précédentes, dans lequel
- la couche de capteur (114) est disposée au départ de la surface de commande (101) derrière la couche de support (102) ; et
- la couche de support (102) est formée sous la forme d'un diffuseur, aménagé afin de disperser la lumière (109) qui traverse la couche de support (102).

5. Composite multicouches (100) selon l'une des revendications précédentes, dans lequel la couche optique (104) comprend,
- un élément de guidage de lumière (106), afin de guider la lumière (109) vers la zone translucide (111) de la surface de capteur (114) ;
- un évidement (605) pour l'accueil de la source lumineuse (105) ; et
- un élément de couplage (108) aménagé afin de coupler la lumière (109) de la source lumineuse (105) dans l'élément de guidage de lumière (106).

6. Composite multicouches (100) selon l'une des revendications précédentes, dans lequel
- le composite multicouches (100) est aménagé afin de mettre à disposition plusieurs éléments de commande (120) disposés l'un à côté de l'autre le long de la surface de commande (101), dans différentes zones d'éléments de commande ; et
- la couche de support (102) comprend, pour les différents éléments de commande (120), des couches de capteurs (104) séparées, isolées électriquement l'une de l'autre, dans les différentes zones d'éléments de commande de la couche de support (102).

7. Composite multicouches (100) selon la revendication 6, dans lequel
- la couche de support (102) comprend pour les différents éléments de commande (120) différentes sources lumineuses (105) dans les différentes zones d'éléments de commande ;
- la couche optique (104) comprend un ou plusieurs élément(s) de séparation optique(s) (607) aménagé(s) afin d'empêcher la lumière (109) émanant d'une source lumineuse (105) dans une première zone d'éléments de commande de déborder dans une deuxième zone d'éléments de commande ; et/ou
- la couche optique (104) comprend un ou plusieurs élément(s) de réflexion optique(s) (606) aménagé(s) afin d'empêcher la lumière (109) émanant d'une source lumineuse (105) dans une première zone d'éléments de commande de se rétroréfléchir en un bord de la première zone d'éléments de commande dans la première zone d'éléments de commande.

8. Composite multicouches (100) selon l'une des revendications 6 à 7, dans lequel le composite multicouches (100) comprend en outre une couche d'obturation opaque (600) disposée au départ de la surface de commande (101) devant la couche de support (102) et qui présente dans les différentes zones d'éléments de commande des évidements translucides (601) pour les différents éléments de commande (120).

9. Composite multicouches (100) selon l'une des revendications précédentes, dans lequel le composite multicouches (100) comprend en outre une couche de réflexion (107) disposée au départ de la surface de commande (101) derrière la couche optique (104) et aménagée afin de rétroréfléchir la lumière (109) dans la couche optique (104).

10. Composite multicouches (100) selon l'une des revendications précédentes, dans lequel le composite multicouches (100) est flexible, de sorte que le composite multicouches (100) peut être disposé, en particulier collé, derrière une surface de commande (101) doublement bombée.

11. Dispositif de commande (300) pour un appareil ménager, dans lequel le dispositif de commande (300) comprend,
- une surface de commande (101) aménagée afin d'être effleurée par un utilisateur sur un premier côté de la surface de commande (101) ;
- un composite multicouches (100) selon l'une des revendications précédentes, disposé, en particulier collé sur un deuxième côté de la surface de commande (101) ; et
- une unité de commande (301) reliée via au moins quelques-uns des câbles (500) du composite multicouches (100) à la couche de capteur (114) du composite multicouches (100) ; dans lequel l'unité de commande (301) est aménagée afin d'ordonner, en fonction d'un signal sur les au moins quelques câbles (500), l'exécution d'une fonction de l'appareil ménager et/ou que la source lumineuse (105) du composite multicouches (100) génère de la lumière (109) ou non.

12. Appareil ménager, en particulier un appareil ménager comprenant un dispositif de commande (300) selon la revendication 11.
